# DEMANDE DE BREVET EUROPEEN

(11) **EP 4 766 070 A1**
(43) Date de publication de la demande: **24.06.2026**
(21) Numéro de dépôt: 25223687.2
(22) Date de dépôt: 16.12.2025
(51) Int. Cl.: H10B 53/30, H10D 1/68, H10D 84/01, H10D 84/80, H10P 50/00, H10W 20/42, H10W 20/40

(54) **PROCÉDÉ DE RÉALISATION D'UN DISPOSITIF FEMFET**

(30) Priorité: 20.12.2024 FR 2414888
(71) Demandeur: Commissariat à l'Energie Atomique et aux Energies Alternatives, 75015 Paris (FR)
(72) Inventeur: CHÊNE, Thibaut, 38054 GRENOBLE Cedex 9 (FR); NEMOUCHI, Fabrice, 38054 GRENOBLE Cedex 9 (FR); SEGAUD, Roselyne, 38054 GRENOBLE Cedex 9 (FR); BOIXADERAS, Christelle, 38054 GRENOBLE Cedex 9 (FR); CHEVOLLEAU, Thierry, 38054 GRENOBLE Cedex 9 (FR); GRENOUILLET, Laurent, 38054 GRENOBLE Cedex 9 (FR)
(74) Mandataire: Hautier IP

(57) **Abrégé**

L'invention concerne un procédé de fabrication d'un dispositif FeMFET comprenant :
- une fourniture d'un transistor (1) comprenant une grille (10), une source (12) et un drain (13) connectés à des vias (14, 15),
- une formation d'une première couche métallique (21),
- une formation d'une couche ferroélectrique (30a),
- une structuration de la couche ferroélectrique (30a) pour former un motif fermé (31) surmontant la grille (10) et des motifs ouverts (32a) surmontant les vias (14, 15),
- une formation d'une deuxième couche métallique (22),
- une gravure de la deuxième couche métallique (22), configurée pour former des vias (221, 222) en s'arrêtant sur la couche ferroélectrique (30a) et,
- une gravure de la première couche métallique (21) de part et d'autre du motif fermé (31) et des motifs ouverts (32a), configurée pour former des lignes (211, 212).

## Description

### DOMAINE TECHNIQUE

La présente invention concerne le domaine technique des dispositifs mémoire pour la microélectronique. Elle trouve pour application particulièrement avantageuse la formation de dispositifs mémoire ferroélectrique intégrés dans les niveaux de fin de ligne d'une puce microélectronique.

### ETAT DE LA TECHNIQUE

Les propriétés ferroélectriques du matériau HfO₂ ou HfₓZr₁₋ₓO₂ (HZO) déposé en couches minces sont particulièrement intéressantes pour l'intégration de mémoires non volatiles dans les niveaux dits « de fin de ligne » ou « BEOL » (acronyme de « Back End of Line ») de la technologie CMOS (acronyme de « Complementary Metal-Oxide-Semiconductor ») pour les nœuds technologiques les plus avancés. Les mémoires à base de HfO2 ferroélectrique de type FeRAM (acronyme de « Ferroelectric Random Access Memory ») sont actuellement développées pour les applications non-volatiles, dans le but de remplacer les mémoires de type Flash. Elles ont notamment pour avantage de présenter une très faible consommation d'énergie. La cellule élémentaire d'une mémoire FeRAM comprend notamment un condensateur ferroélectrique dans lequel l'information est stockée sous la forme de l'état de polarisation des dipôles électriques. En connectant le condensateur ferroélectrique HfO2 à la grille d'un transistor à effet de champ, un dispositif communément appelé FeMFET (acronyme de « Ferroelectric Metal Field Effect Transistor ») peut également être formé. Ce type de « transistor ferroélectrique » FeMFET présente avantageusement une tension de seuil variable en fonction de l'état de polarisation du condensateur ferroélectrique. La densité d'information stockée dans un tel dispositif peut être augmentée. Un tel dispositif FeMFET permet également d'envisager des calculs « dans la mémoire » (communément appelé « In-Memory Computing ») permettant de diminuer la consommation énergétique des systèmes électroniques.

Une solution connue pour intégrer ce type de dispositif dans les niveaux « Back End » consiste à former d'abord les condensateurs ferroélectriques sur les grilles de transistors CMOS, par l'intermédiaire d'un masque de lithographie dédié. Les vias d'interconnexions sont ensuite formés de façon classique, par exemple selon une approche dite « damascène ». Cela augmente le nombre d'étapes et le coût du procédé. Il existe notamment un besoin visant à optimiser le procédé de réalisation de dispositifs FeMFET au moins en partie intégrés dans le « Back End ».

Un objet de la présente invention est de répondre à ce besoin, en palliant tout ou partie des inconvénients mentionnés ci-dessus.

En particulier, un objet de la présente invention est de proposer un procédé de formation d'un dispositif FeMFET présentant un coût réduit. Un autre objet de la présente invention est de proposer un procédé de formation d'un dispositif FeMFET qui présente un nombre d'étapes limité.

### RESUME

Pour atteindre cet objectif, selon un mode de réalisation on prévoit un dispositif FeMFET comprenant, en empilement suivant une direction z :
- un transistor comprenant une grille surmontant un canal, une source et un drain de part et d'autre du canal,
- au moins une interconnexion connectant la source ou le drain, comprenant :
   - au moins une ligne métallique à base d'un premier métal, et,
   - au moins un via métallique à base d'un deuxième métal, connecté à ladite au moins une ligne métallique,
   - une couche d'arrêt de gravure intercalée entre l'au moins un via et l'au moins une ligne, ladite couche d'arrêt de gravure comprenant au moins une ouverture de via de sorte que l'au moins un via et l'au moins une ligne sont connectés au travers de ladite au moins une ouverture de via,
- un condensateur ferroélectrique connectant la grille, comprenant :
   - au moins une ligne métallique à base du premier métal, et,
   - au moins un via métallique à base du deuxième métal,
   - une première partie d'une couche ferroélectrique intercalée entre l'au moins un via et l'au moins une ligne, ladite couche ferroélectrique séparant l'au moins un via et l'au moins une ligne.

Un dispositif FeMFET au moins en partie intégré dans le « Back End », connecté par des interconnexions, est avantageusement réalisé. Les formations des interconnexions et du condensateur ferroélectrique peuvent avantageusement se faire lors des mêmes étapes de gravure.

L'invention prévoit également des procédés de réalisation d'un tel dispositif FeMFET.

Les avantages décrits ci-dessus en regard du dispositif s'appliquent *mutatis mutandis* aux procédés selon l'invention.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 13A illustrent schématiquement en coupe transverse, dans un plan xz, différentes étapes du procédé de fabrication d'un dispositif FeMFET selon un premier mode de réalisation de la présente invention.
Les figures 1B à 13B illustrent schématiquement en perspective, les étapes du procédé de fabrication d'un dispositif FeMFET illustrées respectivement aux figures 1A à 13A, selon le premier mode de réalisation de la présente invention.
Les figures 14A à 24A illustrent schématiquement en coupe transverse, dans un plan xz, différentes étapes du procédé de fabrication d'un dispositif FeMFET selon un deuxième mode de réalisation de la présente invention.
Les figures 14B à 24B illustrent schématiquement en perspective, les étapes du procédé de fabrication d'un dispositif FeMFET illustrées respectivement aux figures 14A à 24A, selon le deuxième mode de réalisation de la présente invention

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs et/ou les dimensions des différentes couches et motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la couche d'arrêt de gravure présente, vis-à-vis de la première couche métallique, une sélectivité S_{21:30b} à la gravure supérieure ou égale à 5:1.

Selon un exemple, la couche ferroélectrique présente une sélectivité à la gravure S_{21:31} supérieure ou égale à 5:1 vis-à-vis du premier métal.

Selon un exemple, la couche d'arrêt de gravure intercalée entre l'au moins un via et l'au moins une ligne de l'au moins une interconnexion est ferroélectrique. La couche d'arrêt de gravure intercalée entre l'au moins un via et l'au moins une ligne de l'au moins une interconnexion correspond typiquement à une deuxième partie de la couche ferroélectrique. La couche ferroélectrique est utilisée ici à la fois comme couche d'arrêt de gravure et comme couche fonctionnelle pour le condensateur ferroélectrique. Cela limite le nombre et la nature des couches dans le dispositif. Le coût de fabrication du dispositif est diminué.

Selon un exemple, l'au moins une interconnexion comprend une première interconnexion connectant la source et une deuxième interconnexion connectant le drain, et chacune des première et deuxième interconnexions comprend une couche d'arrêt de gravure intercalée entre l'au moins un via et l'au moins une ligne de ladite interconnexion. Toutes les interconnexions du dispositif présentent typiquement une partie de couche d'arrêt de gravure intercalée entre deux niveaux métalliques successifs desdites interconnexions. Dans cet exemple, la couche d'arrêt de gravure peut être ferroélectrique ou non ferroélectrique.

Selon un exemple, les vias connectant la source et le drain du transistor sont obtenus selon une approche « damascène ». Après formation de la grille et des source et drain du transistor, une couche diélectrique est déposée sur les source et drain. Cette couche diélectrique est typiquement planarisée de façon à exposer une face supérieure de la grille. Des ouvertures débouchant sur les source et drain du transistor sont formées au sein de la couche diélectrique, puis remplies par un métal. Une planarisation est effectuée de façon à retirer le métal en surface de la couche diélectrique et de la face supérieure de la grille. Des vias connectant les source et drain, et présentant des faces exposées coplanaires avec la face supérieure de la grille, sont ainsi obtenus. La surface supérieure du transistor fourni, comprenant les faces exposées des vias et de la grille, est avantageusement plane. Cela facilite les dépôts ultérieurs, en particulier le dépôt de la première couche métallique et/ou le dépôt de la couche ferroélectrique.

Selon un exemple, la couche ferroélectrique présente une épaisseur e₃₀ₐ comprise entre 2 nm et 15 nm, préférentiellement entre 7 nm et 10 nm.

Selon un exemple, la couche ferroélectrique est à base d'un matériau pris parmi : HfₓZr₁₋ₓO₂, HfO₂. Le matériau HfO2 peut être non dopé ou dopé. Selon un exemple, le matériau HfO2 est dopé par l'un au moins parmi les éléments suivants : Si, N, Gd, Y, Sc, Ge. La concentration en éléments dopants est typiquement comprise entre 0% et 10%at., préférentiellement entre 0,5% et 3%at.

Selon un exemple, la structuration de la couche ferroélectrique comprend les sous-étapes suivantes :
- une formation du premier masque sur la couche ferroélectrique, ledit premier masque définissant de façon directe l'au moins un motif fermé et l'au moins un motif ouvert comprenant l'au moins une ouverture de via,
- un retrait partiel de la couche ferroélectrique, uniquement au niveau de zones de la couche ferroélectrique non couvertes par le premier masque, de façon à exposer la première couche métallique en dehors des zones couvertes par le premier masque,
- un retrait du premier masque.

Dans cet exemple, les parties couvertes par le premier masque correspondent aux motifs ouverts et fermés. L'électrode inférieure du condensateur ferroélectrique et les lignes du premier niveau participant aux interconnexions de source et drain sont définies grâce au seul premier masque.

Selon un exemple, le retrait partiel de la couche ferroélectrique se fait par gravure à base d'une chimie chlorée BCl₃.

Selon un exemple, la formation du premier masque se fait par double lithographie. Ce procédé connu de lithographie permet d'optimiser, voire de dépasser les limitations en résolution d'un équipement d'insolation classique de lithographie. Une autre solution consiste à utiliser un équipement de lithographie mieux résolu, par exemple en extrême UV ou en lithographie électronique. La formation du premier masque peut comprendre une première lithographie suivie d'une deuxième lithographie, puis une gravure. Alternativement, la formation du premier masque peut comprendre une première lithographie suivie d'une première gravure, puis une deuxième lithographie suivie d'une deuxième gravure.

Selon un exemple, le premier masque est à base d'un matériau non métallique, par exemple à base de SiON, SiN, SiCN, HfO2, SiON, SiC.

Selon un exemple, le ou les vias du deuxième niveau surmontant le ou les motifs fermés présentent une dimension critique CDᵥᵢₐ₂₂₁, prise selon un axe x, inférieure à une dimension CD₁, prise selon l'axe x, du ou des motifs fermés. Cela permet de minimiser le risque lié à un désalignement entre les premier et deuxième masques. Les lignes du premier niveau étant typiquement plus larges que les vias du deuxième niveau, la gravure de la deuxième couche métallique, associée à la formation des vias du deuxième niveau, s'arrêtera effectivement sur la couche ferroélectrique, structurée selon le ou les motifs fermés. La fiabilité du procédé est augmentée.

Selon un exemple, le ou les vias du deuxième niveau surmontant le ou les motifs ouverts présentent une dimension critique CDᵥᵢₐ₂₀, prise selon un axe x, supérieure ou égale à une dimension CDₒₚₑₙ de l'au moins une ouverture de via prise selon l'axe x. Cela permet de minimiser le risque lié à un désalignement entre les premier et deuxième masques. Les vias du deuxième niveau étant typiquement plus larges que les ouvertures de via, l'alignement du deuxième masque définissant les vias à l'aplomb des ouvertures de via est facilité. La gravure de la deuxième couche métallique, lors de la formation des vias du deuxième niveau, s'arrêtera effectivement sur la couche ferroélectrique, structurée selon le ou les motifs ouverts. La gravure de la deuxième couche métallique ne se prolonge pas au niveau des ouvertures de via. La fiabilité du procédé est augmentée.

Selon un exemple, les première et deuxième couches métalliques sont à base d'un même matériau métallique, par exemple TaN, TiN, AI, Ru, Mo.

Selon un exemple, la gravure de la deuxième couche métallique et la gravure de la première couche métallique sont réalisées par une seule et même gravure, lors d'une seule et même étape.

Selon un exemple, les première et deuxième couches métalliques sont respectivement à base d'un premier matériau métallique et d'un deuxième matériau métallique, lesdits premier et deuxième matériaux métalliques étant différents entre eux.

Selon un exemple, la gravure de la deuxième couche métallique et la gravure de la première couche métallique sont réalisées par deux gravures successives différentes.

Selon un exemple on prévoit un procédé de fabrication d'un dispositif FeMFET comprenant :
- une fourniture d'un transistor comprenant une grille surmontant un canal, une source et un drain de part et d'autre du canal, et des vias connectant la source et le drain, lesdits vias et ladite grille présentant chacun une face exposée au niveau d'une surface supérieure,
- une formation d'une première couche métallique sur les faces exposées de la surface supérieure,
- une formation, sur la première couche métallique, d'une couche ferroélectrique à base d'un matériau ferroélectrique présentant, vis-à-vis de la première couche métallique, une sélectivité S_{21:30a} à la gravure supérieure ou égale à 5:1,
- une structuration de la couche ferroélectrique, par l'intermédiaire d'au moins un premier masque, de façon à exposer des parties de la première couche métallique et à conserver des parties de la couche ferroélectrique sous forme d'au moins un motif fermé surmontant la grille du transistor et au moins un motif ouvert surmontant au moins un des vias connectant la source ou le drain, ledit au moins un motif ouvert comprenant au moins une ouverture de via débouchant sur la première couche métallique sous-jacente,
- une formation d'une deuxième couche métallique sur les parties exposées de la première couche métallique et sur l'au moins un motif fermé et l'au moins un motif ouvert,
- une formation, sur la deuxième couche métallique, d'un deuxième masque définissant au moins un deuxième niveau de vias à l'aplomb de l'au moins un motif fermé et à l'aplomb de l'au moins une ouverture de via de l'au moins un motif ouvert,
- une gravure de la deuxième couche métallique, ladite gravure étant configurée pour former les vias du deuxième niveau en s'arrêtant sur la couche ferroélectrique et,
- une gravure de la première couche métallique de part et d'autre de l'au moins un motif fermé et de l'au moins un motif ouvert, ladite gravure étant configurée pour former des lignes de premier niveau en s'arrêtant sur la surface supérieure.

Les vias du deuxième niveau surmontant les motifs ouverts sont connectés aux lignes du premier niveau au travers de l'au moins une ouverture de via. Ces lignes du premier niveau sont elles-mêmes connectées aux vias connectant la source et le drain du transistor. Des interconnexions vers la source et le drain du transistor sont ainsi formées au travers de plusieurs niveaux métalliques.

Dans cet exemple, les vias du deuxième niveau surmontant les motifs fermés sont séparés des lignes du premier niveau par le matériau ferroélectrique. Un condensateur ferroélectrique est ainsi formé entre plusieurs niveaux métalliques. L'électrode inférieure du condensateur ferroélectrique et les lignes du premier niveau participant aux interconnexions de source et drain sont formées à partir de la première couche métallique.

Un dispositif **FeMFET** au moins en partie intégré dans le « Back End », connecté par des interconnexions, est avantageusement réalisé. Les formations des interconnexions et du condensateur ferroélectrique se font avantageusement lors des mêmes étapes de gravure.

Ce procédé recourt à une couche ferroélectrique structurée et enterrée entre les première et deuxième couches métalliques. Cette couche ferroélectrique, qui présente une sélectivité S_{21:30a} à la gravure supérieure ou égale à 5:1, fait avantageusement office de couche d'arrêt de gravure. Une telle couche d'arrêt de gravure intercalaire permet avantageusement d'effectuer la ou les gravures des couches métalliques successivement, par exemple en une seule étape ou de façon enchaînée. Le nombre d'étapes du procédé est ainsi limité.

Selon un autre exemple, on prévoit un procédé de fabrication d'un dispositif **FeMFET** comprenant :
- une fourniture d'un transistor comprenant une grille surmontant un canal, une source et un drain de part et d'autre du canal, et des vias connectant la source et le drain, lesdits vias et ladite grille présentant chacun une face exposée au niveau d'une surface supérieure,
- une formation d'une première couche métallique sur les faces exposées de la surface supérieure,

- une formation, sur la première couche métallique, d'une couche d'arrêt de gravure,
- une structuration de la couche d'arrêt de gravure, par l'intermédiaire d'au moins un premier masque, de façon à exposer des parties de la première couche métallique et à conserver des parties de la couche d'arrêt de gravure sous forme d'au moins un motif ouvert surmontant la grille et au moins un des vias connectant la source ou le drain, ledit au moins un motif ouvert comprenant au moins une ouverture de via débouchant sur la première couche métallique sous-jacente,
- une formation d'une deuxième couche métallique sur les parties exposées de la première couche métallique et sur l'au moins un motif ouvert,
- une formation, sur la deuxième couche métallique, d'une couche ferroélectrique à base d'un matériau ferroélectrique présentant, vis-à-vis de la deuxième couche métallique, une sélectivité S_{22:30a} à la gravure supérieure ou égale à 5:1,
- une structuration de la couche ferroélectrique, par l'intermédiaire d'au moins un deuxième masque, de façon à exposer des parties de la deuxième couche métallique et à conserver des parties de la couche ferroélectrique sous forme d'au moins un motif fermé surmontant la grille du transistor,
- une formation d'une troisième couche métallique sur les parties exposées de la deuxième couche métallique et sur l'au moins un motif fermé,
- une formation, sur la troisième couche métallique, d'un troisième masque définissant des vias à l'aplomb de l'au moins un motif fermé et à l'aplomb de l'au moins une ouverture de via de l'au moins un motif ouvert,
- au moins une gravure des troisième, deuxième et première couches métalliques, ladite au moins une gravure étant configurée pour former les vias en s'arrêtant sur la couche ferroélectrique et sur la couche d'arrêt de gravure, et pour former des lignes en s'arrêtant sur la surface supérieure.

Dans cet exemple, l'électrode inférieure du condensateur ferroélectrique est formée à partir des première et deuxième couches métalliques. Les lignes du premier niveau participant aux interconnexions de source et drain sont formées à partir de la première couche métallique.

Dans cet exemple, le condensateur ferroélectrique est formé au sein des niveaux d'interconnexions supérieurs. Il peut être relativement éloigné du transistor auquel il est associé. La couche ferroélectrique forme uniquement le motif fermé. La couche d'arrêt de gravure sous-jacente forme un motif ouvert. Cela permet d'envisager différentes combinaisons de motifs fermés et ouverts. Le dimensionnement de l'électrode inférieure du condensateur et/ou de la couche ferroélectrique de séparation du condensateur est mieux contrôlé. La sélectivité de gravure entre les différentes couches métalliques et la couche diélectrique peut être ajustée, par exemple réduite.

Sauf incompatibilité, il est entendu que l'ensemble des caractéristiques optionnelles ci-dessus et/ou les variantes indiquées peuvent être combinées de façon à former un mode de réalisation qui n'est pas nécessairement illustré ou décrit. Un tel mode de réalisation n'est évidemment pas exclu de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage. Ainsi, une couche d'arrêt de gravure à base de nitrure de silicium SiN peut par exemple comprendre du nitrure de silicium non stœchiométrique (SiN), ou du nitrure de silicium staechiométrique (Si₃N₄), ou encore un oxy-nitrure de silicium (SiON).

On entend par motif fermé un motif qui ne communique pas avec la couche sous-jacente. A contrario, on entend par motif ouvert un motif qui communique avec la couche sous-jacente à travers une ouverture, typiquement à travers une ouverture de via.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé. Les gravures des première et deuxième couches métalliques peuvent notamment être enchaînées ou être considérées comme faisant partie d'une seule et même étape de gravure.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée S_{A:B}. Une sélectivité S_{A:B} de 10:1 signifie que la vitesse de gravure du matériau A est 10 fois supérieure à la vitesse de gravure du matériau B.

Un repère de préférence orthonormé, comprenant les axes x, y, z est représenté sur les figures annexées.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche métallique présente typiquement une épaisseur selon z. Un via formé à partir d'une telle couche métallique présente une hauteur selon z. Les termes relatifs « sur », « surmonte », « supérieur », « sous », « sous-jacent » « inférieur » se réfèrent à des positions prises selon la direction z. Une dimension « latérale » correspond à une dimension selon une direction du plan xy. On entend par une extension « latérale » ou « latéralement », une extension selon une ou des directions du plan xy.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

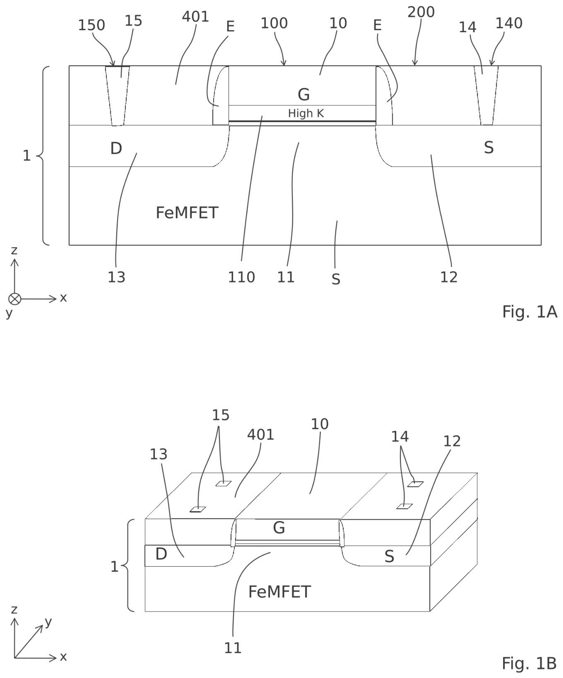

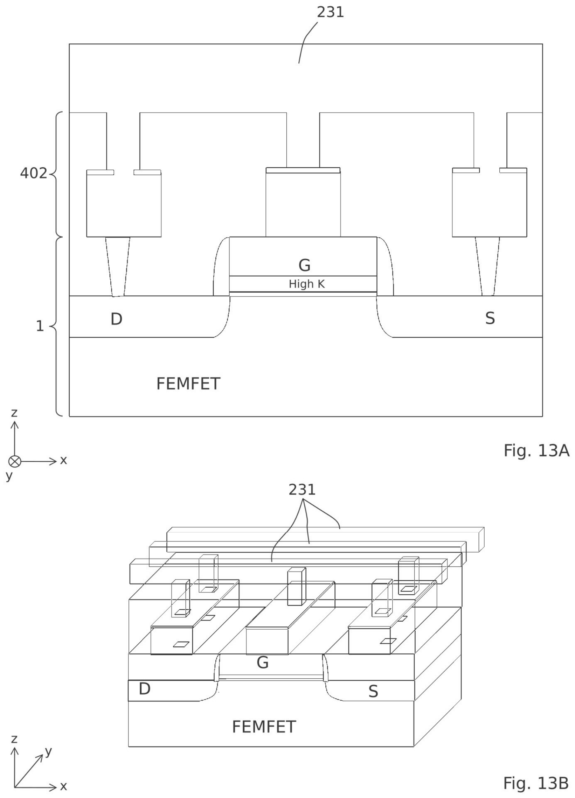

Des étapes de fabrication d'un dispositif FeMFET selon un premier mode de réalisation de l'invention sont illustrées aux figures 1A, 1B à 13A, 13B.

Comme illustré aux figures 1A, 1B, le procédé comprend une fourniture d'un transistor 1 par exemple de type MOS (métal-oxyde-semiconducteur). Ce transistor 1 comprend typiquement un substrat S à base de silicium, une grille 10 surmontant le substrat S, une source 12 et un drain 13 de part et d'autre de la grille 10, par exemple au sein du substrat S, et un canal 11 sous la grille 10 et séparé de la grille 10 par une ou plusieurs couches diélectriques 110. La grille 10 est typiquement flanquée par des espaceurs E.

Le transistor 1 comprend ici également les vias 14, 15 connectant respectivement la source 12 et le drain 13 du transistor. Ces vias 14, 15 sont de préférence obtenus selon une approche « damascène ». Selon cette approche, après formation de la grille 10 et des source 12 et drain 13 du transistor, une couche diélectrique 401 est déposée. Cette couche diélectrique 401 est typiquement planarisée par polissage mécano-chimique CMP de façon à exposer une face supérieure 100 de la grille 10. Des ouvertures débouchant sur les source 12 et drain 13 du transistor sont formées au sein de la couche diélectrique 401, puis remplies par un métal. Une planarisation, par exemple par CMP, est effectuée de façon à retirer le métal en surface de la couche diélectrique 401 et de la face supérieure de la grille 10. Les vias 14, 15 sont ainsi obtenus. Ils présentent respectivement des faces exposées 140, 150 coplanaires avec la face supérieure 100 de la grille 10. La surface supérieure 200 de ce transistor 1, comprenant les faces exposées 140, 150, 100, est avantageusement plane.

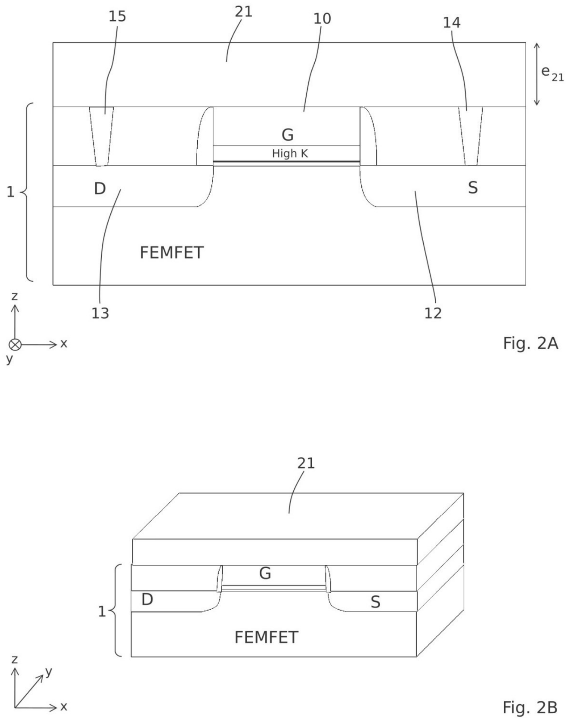

Comme illustré aux figures 2A, 2B, une première couche métallique 21, typiquement à base d'un métal pris parmi TaN, TiN, AI, Ru, Mo, est d'abord formée sur la surface 200 du transistor 1. Les vias 14, 15 et la grille 10 sont directement en contact avec la couche métallique 21. Cette couche métallique 21 présente typiquement une épaisseur e₂₁ de l'ordre de quelques dizaines de nanomètres à quelques centaines de nanomètres, par exemple entre 20 nm et 200 nm. Le dépôt de cette couche métallique 21 peut notamment être effectué par l'une des techniques suivantes: dépôt physique en phase vapeur (PVD, acronyme de « physical vapor deposition »), dépôt chimique en phase vapeur (CVD, acronyme de « chemical vapor deposition »), dépôt par couche atomique (ALD, acronyme de « atomic layer deposition »). Après dépôt, la première couche métallique 21 peut être planarisée, par exemple par CMP. La première couche métallique 21 correspond typiquement à un premier niveau de métal.

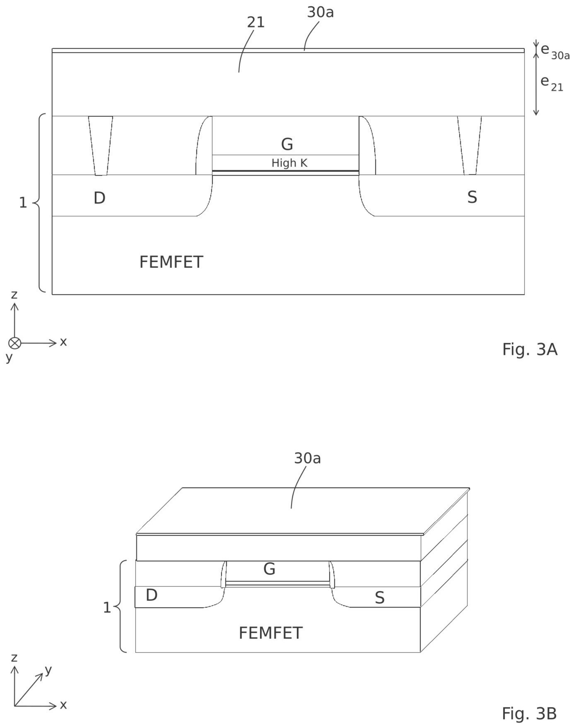

Comme illustré aux figures 3A, 3B, une couche ferroélectrique 30a est ensuite directement formée sur la première couche métallique 21. Cette couche ferroélectrique 30a présente typiquement une épaisseur e₃₀ₐ de l'ordre de quelques nanomètres, par exemple entre 2 nm et 15 nm. Elle est de préférence à base d'un matériau pris parmi : HfₓZr₁₋ₓO₂, HfO₂. Le dépôt de cette couche ferroélectrique 30a est de préférence effectué par ALD.

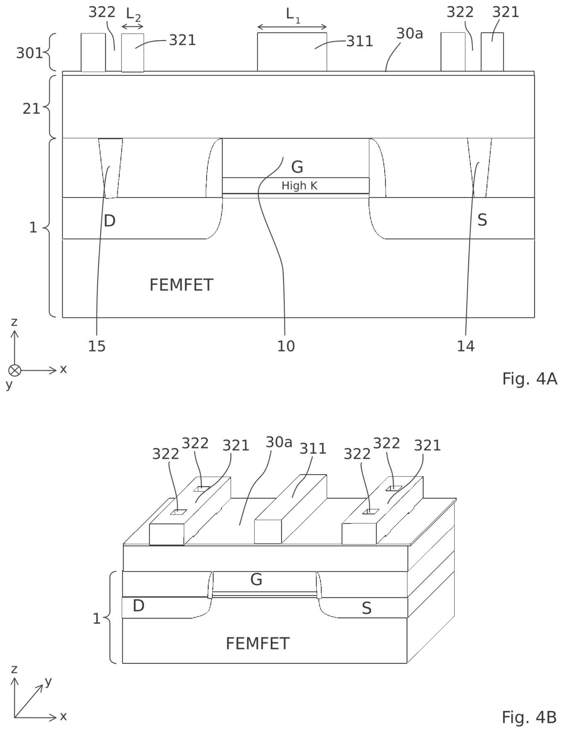

Comme illustré aux figures 4A, 4B, un masque de gravure 301 est formé sur la couche ferroélectrique 30a. Ce masque de gravure 301 est par exemple à base de SiON. Il est typiquement obtenu par lithographie/gravure, par exemple par l'intermédiaire d'une lithographie simple en insolation extrême UV, ou par l'intermédiaire d'une double lithographie, également appelée « double patterning ».

Le masque de gravure 301 comprend un motif plein 311 au-dessus de la grille 10 du transistor 1, et des motifs ouverts 321 au-dessus des vias 14, 15. Les motifs ouverts 321 comprennent une ou plusieurs ouvertures 322 débouchant sur la couche ferroélectrique 30a sous-jacente. Le motif plein 311 présente typiquement une dimension L₁ selon x comprise entre 20 nm et 300 nm, en fonction de la technique de lithographie mise en œuvre. Les motifs ouverts 321 présentent typiquement une dimension L₂ selon x comprise entre 8 nm et 150 nm, en fonction de la technique de lithographie mise en œuvre.

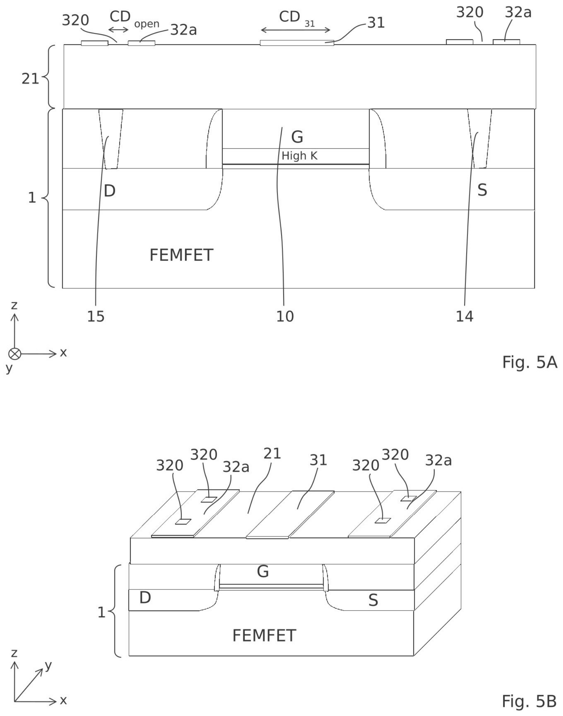

Comme illustré aux figures 5A, 5B, les motifs 311, 321 sont transférés dans la couche ferroélectrique 30a par gravure anisotrope selon z de la couche ferroélectrique 30a en présence du masque 301. La gravure de la couche ferroélectrique 30a peut être effectuée par plasma à base d'une chimie de gravure chlorée, par exemple BCl, BCl₃. Le motif plein 311 du masque 301 forme après gravure le motif fermé 31 dans la couche ferroélectrique 30a. Les motifs ouverts 321 du masque 301 forment après gravure les motifs ouverts 32a comprenant les ouvertures de via 320 dans la couche ferroélectrique 30a. Les motifs 31, 32a présentent sensiblement les mêmes dimensions que les motifs 311, 321. Le motif fermé 31 présente typiquement la dimension CD₃₁ selon x, et les ouvertures de via 320 des motifs ouverts 32a présentent typiquement la dimension CDₒₚₑₙ selon x. Le masque 301 est retiré après gravure, par exemple par plasma à base d'oxygène ou d'hydrogène.

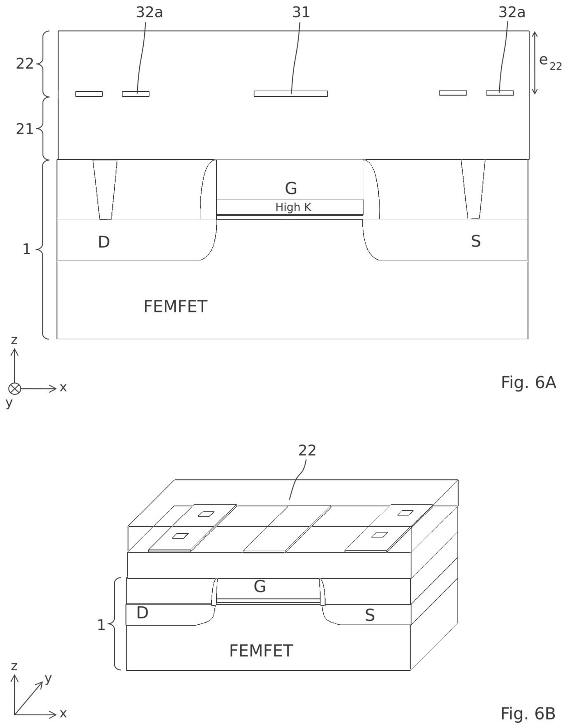

Comme illustré aux figures 6A, 6B, après structuration de la couche ferroélectrique 30a, une deuxième couche métallique 22, typiquement à base d'un métal pris parmi TaN, TiN, AI, Ru, Mo, est ensuite formée sur la première couche métallique 21, et sur le motif fermé 31 et les motifs ouverts 32a. Cette couche métallique 22 présente typiquement une épaisseur e₂₂ de l'ordre de quelques dizaines de nanomètres à quelques centaines de nanomètres, par exemple entre 20 nm et 200 nm. Le dépôt de cette couche métallique 22 peut notamment être effectué par PVD, CVD ou ALD. Après dépôt, la deuxième couche métallique 22 peut être planarisée, par exemple par CMP. La deuxième couche métallique 22 correspond typiquement à un deuxième niveau de métal.

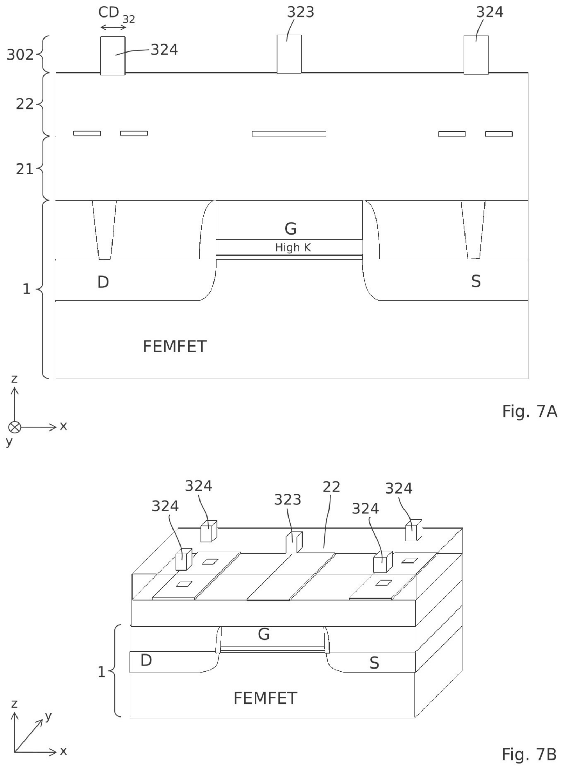

Comme illustré aux figures 7A, 7B, un deuxième masque de gravure 302 comprenant des motifs de vias 323, 324 est formé sur la deuxième couche métallique 22. Ce deuxième masque de gravure 302 est de préférence à base de couches organiques, par exemple sous forme d'un empilement connu sous la dénomination « trilayer », comprenant typiquement une couche de planarisation organique, une couche antireflets et une couche de résine photosensible.

Les motifs de vias 324 de ce deuxième masque de gravure 302 sont alignés à l'aplomb des ouvertures de via 320 des motifs ouverts 32a. Le motif de via 323 de ce deuxième masque de gravure 302 est aligné à l'aplomb du motif fermé 31. Les motifs de vias 324 présentent typiquement une dimension CD₃₂ selon x légèrement supérieure, par exemple 10% supérieure, à la dimension CDₒₚₑₙ selon x des ouvertures de via 320 des motifs ouverts 32a. Cela facilite l'alignement des motifs 324, 32a entre eux. Une certaine tolérance sur la précision d'alignement est ainsi obtenue. La dimension CD₃₂ selon x des motifs de vias 324 est par exemple comprise entre 10 nm et 150 nm.

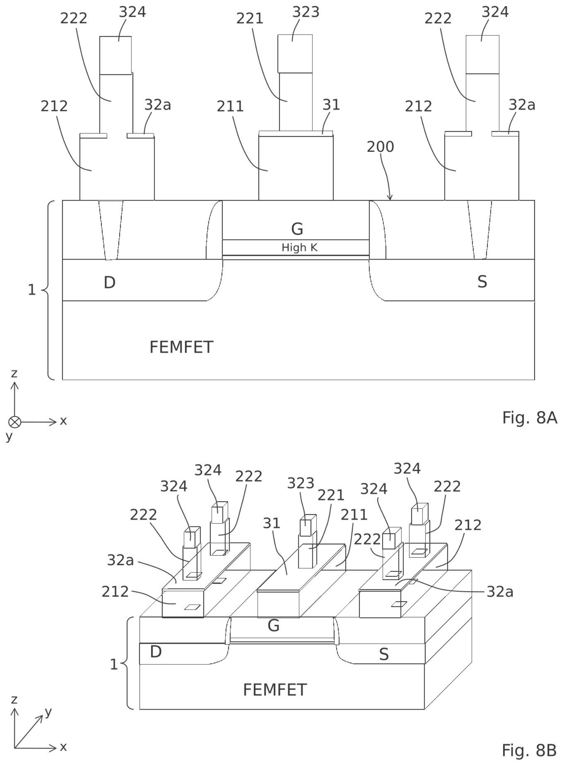

Comme illustré aux figures 8A, 8B, les première et deuxième couches métalliques 21, 22 sont ensuite gravées sur toute leur épaisseur, selon z, de part et d'autre des motifs de vias 323, 324 et de part et d'autre des motifs ouverts 32a et du motif fermé 31. La deuxième couche métallique 22 est d'abord gravée pour former les vias 222, 221, puis la première couche métallique 21 est gravée pour former les lignes 212, 211. Les gravures des première et deuxième couches métalliques 21, 22 sont de préférence enchaînées. Selon une possibilité, notamment lorsque les première et deuxième couches métalliques 21, 22 sont de nature identique, les gravures de ces couches métalliques 21, 22 sont effectuées en une seule et même étape, avec la même chimie de gravure.

Les gravures sont ici choisies de façon à graver sélectivement les premier et deuxième métaux des première et deuxième couches métalliques 21, 22 vis-à-vis du matériau de la couche ferroélectrique (structurée sous forme des motifs 31, 32a). La couche ferroélectrique est ici avantageusement utilisée comme couche d'arrêt de gravure. En particulier, la sélectivité de gravure S_{21:30a}, c'est-à-dire le rapport entre la vitesse de gravure du métal de la première couche métallique 21 sur la vitesse de gravure du matériau de la couche ferroélectrique, est supérieure ou égale à 5:1, de préférence supérieure ou égale à 10:1. Les gravures peuvent être à base d'une chimie de type CF₄/H₂.

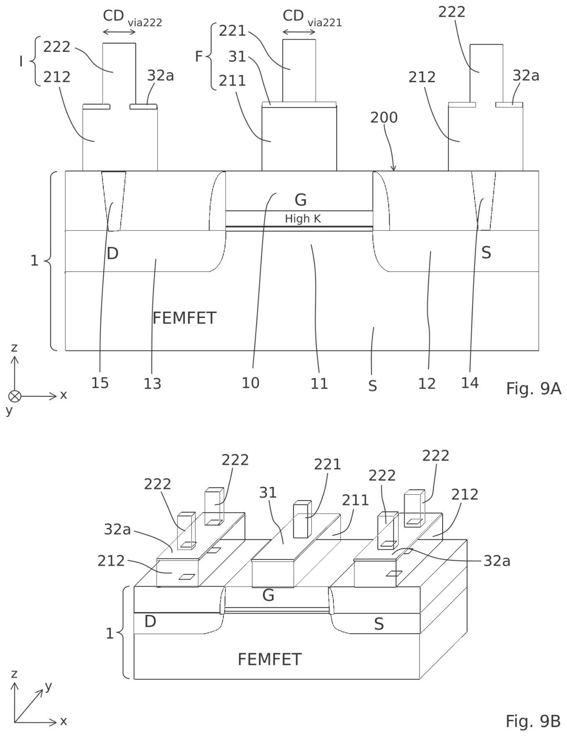

Comme illustré aux figures 9A, 9B, après gravure, le masque 302 est retiré, par exemple par plasma à base d'oxygène. Des vias 222 présentant la dimension CDᵥᵢₐ₂₂₂ selon x sont obtenus au-dessus des motifs ouverts 32a. La dimension CDᵥᵢₐ₂₂₂ est sensiblement égale à la dimension CD₃₂ des motifs de vias 324. Un via 221 présentant la dimension CDᵥᵢₐ₂₂₁ selon x est obtenu au-dessus du motif fermé 31. Un dispositif FeMFET comprenant des interconnexions I (212, 222) et un condensateur ferroélectrique F (211, 31, 221) intégré dans les niveaux d'interconnexions est ainsi avantageusement obtenu. Le condensateur ferroélectrique F comprend ici une électrode inférieure formée par la ligne 211, une électrode supérieure formée par le via 221, et une couche de séparation ferroélectrique 31 entre les électrodes inférieure et supérieure. Le condensateur ferroélectrique F est ici intégré entre les premier et deuxième niveaux de métal.

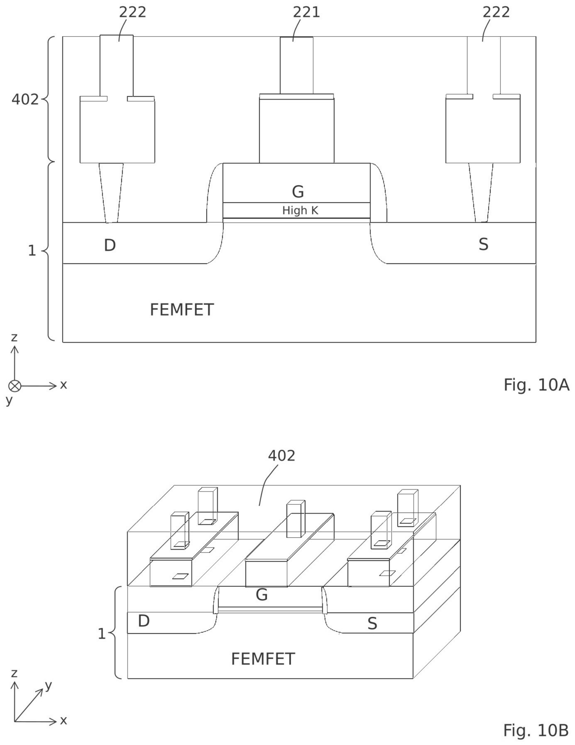

Comme illustré aux figures 10A, 10B, les interconnexions I et le condensateur ferroélectrique F sont ensuite classiquement intégrés dans une matrice diélectrique par dépôt et planarisation d'une couche diélectrique 402, typiquement à base de SiO₂.

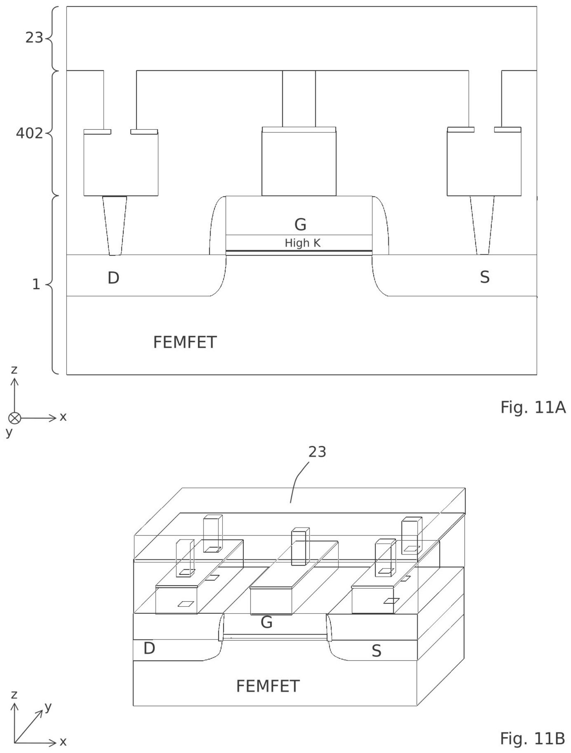

Comme illustré aux figures 11A, 11B, une troisième couche métallique 23 par exemple à base de TaN, TiN, AI, Ru, Mo, correspondant à un troisième niveau de métal, peut ensuite être déposée sur la couche 402 et les vias 221, 222 affleurant.

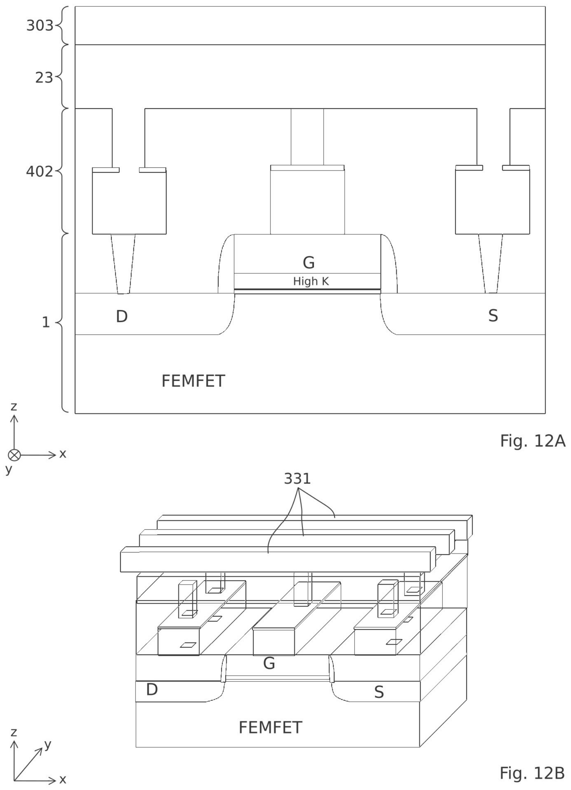

Comme illustré aux figures 12A, 12B, un troisième masque 303 comprenant par exemple des motifs de ligne 331 peut être formé sur la troisième couche métallique 23.

Comme illustré aux figures 13A, 13B, la troisième couche métallique 23 est ensuite structurée par gravure au travers du masque 303. Des lignes 231 sont ainsi formées dans le troisième niveau de métal. Ces lignes 231 connectent typiquement les vias 221, 222 du deuxième niveau de métal.

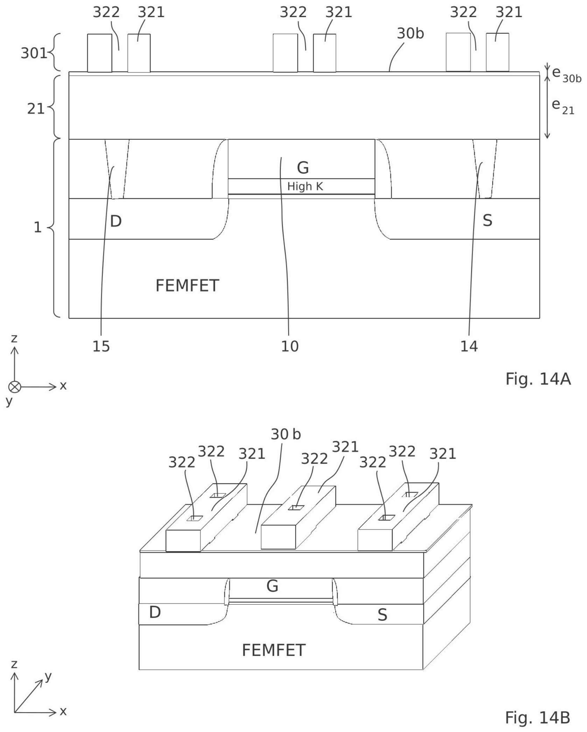

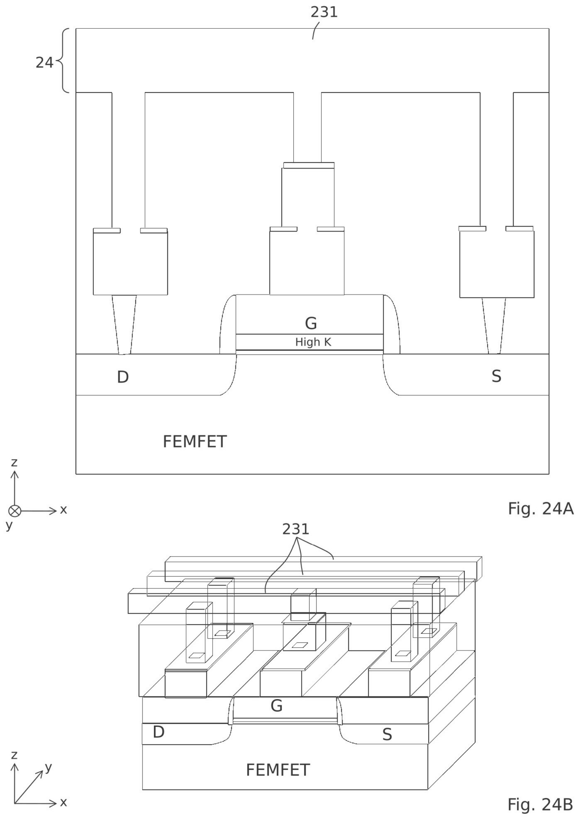

Les figures 14A, 14B à 24A, 24B illustrent des étapes de fabrication d'un dispositif FeMFET selon un deuxième mode de réalisation de l'invention. Dans ce deuxième mode de réalisation, le condensateur ferroélectrique du dispositif FeMFET est intégré dans des niveaux d'interconnexions supérieurs. Seules les étapes et caractéristiques différentes du premier mode de réalisation sont détaillées ci-après, les autres étapes et caractéristiques étant réputées identiques à celles du premier mode de réalisation.

Comme illustré aux figures 14A, 14B, après formation de la première couche métallique 21, une couche d'arrêt de gravure 30b est directement formée sur la première couche métallique 21. Cette couche d'arrêt de gravure 30b présente typiquement une épaisseur e_{30b} de l'ordre de quelques nanomètres, par exemple entre 2 nm et 15 nm. Elle est de préférence à base d'un matériau diélectrique pris parmi : SiO₂, TiO₂, HfO₂, HfN, ZrN, SiN, SiCN. Le dépôt de cette couche d'arrêt de gravure 30b est de préférence effectué par ALD. Comme précédemment, un masque de gravure 301 est formé sur la couche d'arrêt de gravure 30b. Ce masque de gravure 301 comprend ici uniquement des motifs ouverts 321 au-dessus des vias 14, 15, et au-dessus de la grille 10 du transistor 1. Les motifs ouverts 321 comprennent une ou plusieurs ouvertures 322 débouchant sur la couche d'arrêt de gravure 30b sous-jacente.

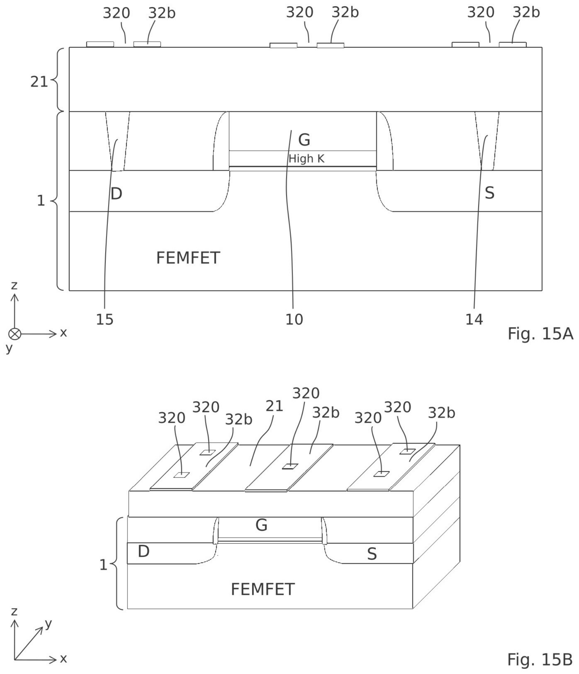

Comme illustré aux figures 15A, 15B, les motifs 321 sont transférés dans la couche d'arrêt de gravure 30b par gravure anisotrope selon z de la couche d'arrêt de gravure 30b en présence du masque 301. Les motifs ouverts 321 du masque 301 forment après gravure les motifs ouverts 32b comprenant les ouvertures de via 320 dans la couche d'arrêt de gravure 30b. Le masque 301 est retiré après gravure, par exemple par plasma à base d'oxygène.

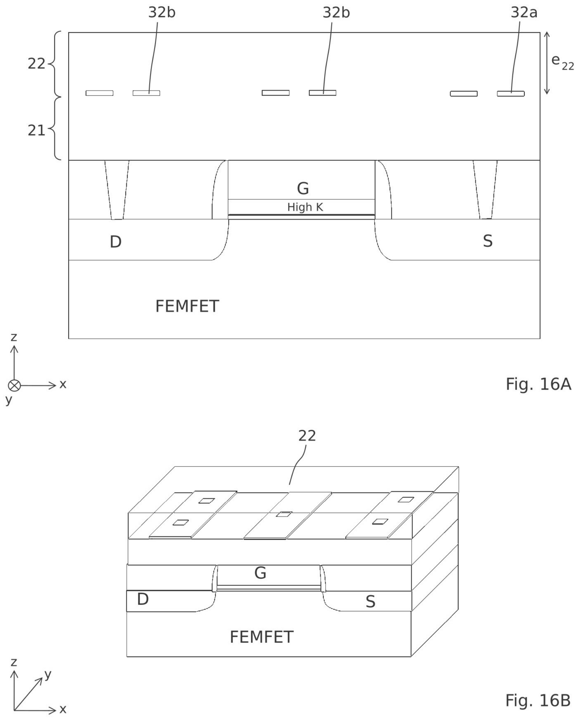

Comme illustré aux figures 16A, 16B, après structuration de la couche d'arrêt de gravure 30b, une deuxième couche métallique 22, typiquement à base d'un métal pris parmi TaN, TiN, Al, Ru, Mo, est ensuite formée sur la première couche métallique 21, et sur les motifs ouverts 32b. La deuxième couche métallique 22 correspond typiquement à un deuxième niveau de métal.

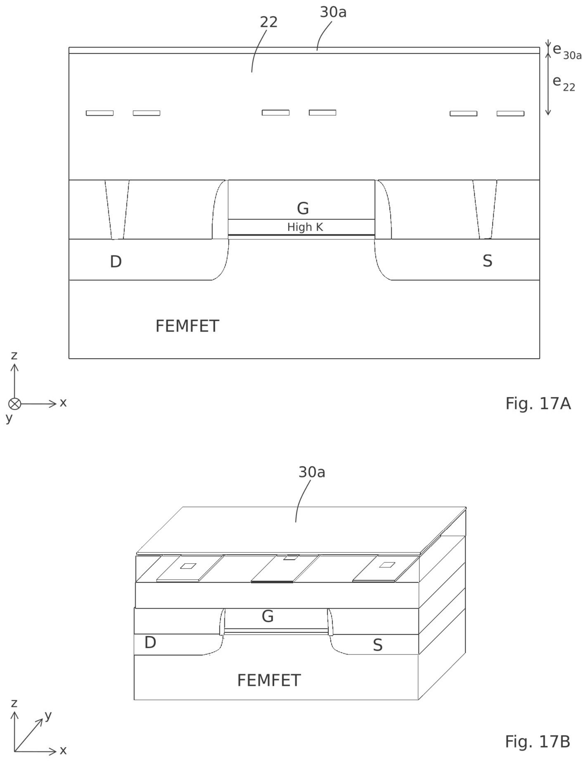

Comme illustré aux figures 17A, 17B, une couche ferroélectrique 30a est ensuite directement formée sur la deuxième couche métallique 22. Cette couche ferroélectrique 30a présente typiquement une épaisseur e₃₀ₐ de l'ordre de quelques nanomètres, par exemple entre 2 nm et 15 nm. Elle est de préférence à base d'un matériau pris parmi : HfₓZr₁₋ₓO₂, HfO₂. Le dépôt de cette couche ferroélectrique 30a est de préférence effectué par ALD.

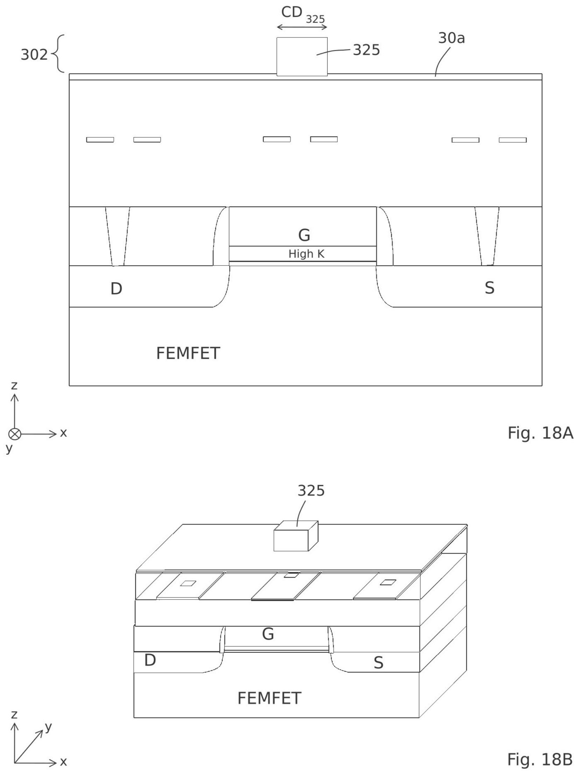

Comme illustré aux figures 18A, 18B, un deuxième masque de gravure 302 comprenant un motif intermédiaire 325 est formé sur la couche ferroélectrique 30a. Ce motif intermédiaire 325 est aligné à l'aplomb de l'ouverture de via 320 du motif ouvert 32b situé au-dessus de la grille 10 du transistor. Ce motifs intermédiaire 325 présente typiquement une dimension CD₃₂₅ selon x supérieure, par exemple au moins 20% supérieure, à la dimension CDₒₚₑₙ selon x de l'ouverture de via 320 du motif ouvert 32b. Cela facilite l'alignement des motifs 325, 32b entre eux. Le dimensionnement de l'électrode inférieure du condensateur et/ou de la couche ferroélectrique de séparation du condensateur est également mieux contrôlé. La dimension CD₃₂₅ selon x du motif intermédiaire 325 est par exemple comprise entre 10 nm et 200 nm.

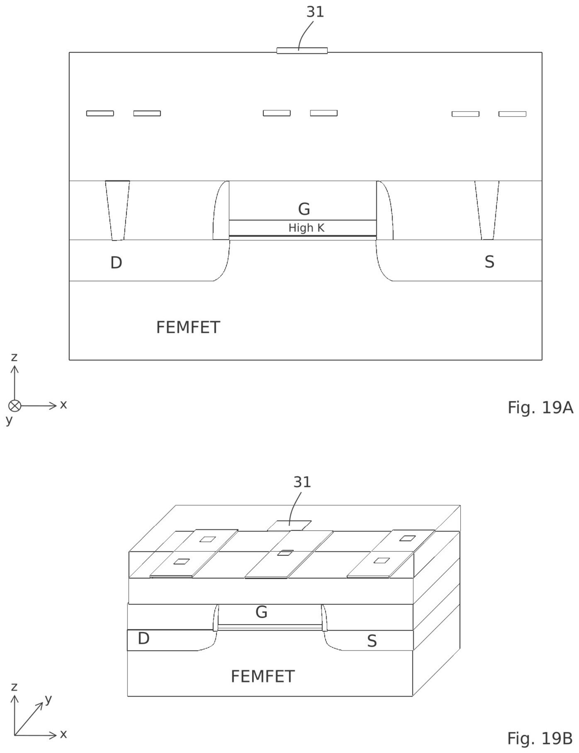

Comme illustré aux figures 19A, 19B, le motif 325 est transféré dans la couche ferroélectrique 30a par gravure anisotrope selon z de la couche ferroélectrique 30a en présence du masque 302. Le motif 325 du masque 302 forme après gravure le motif fermé 31 dans la couche ferroélectrique 30a. Le masque 302 est retiré après gravure, par exemple par plasma à base d'oxygène.

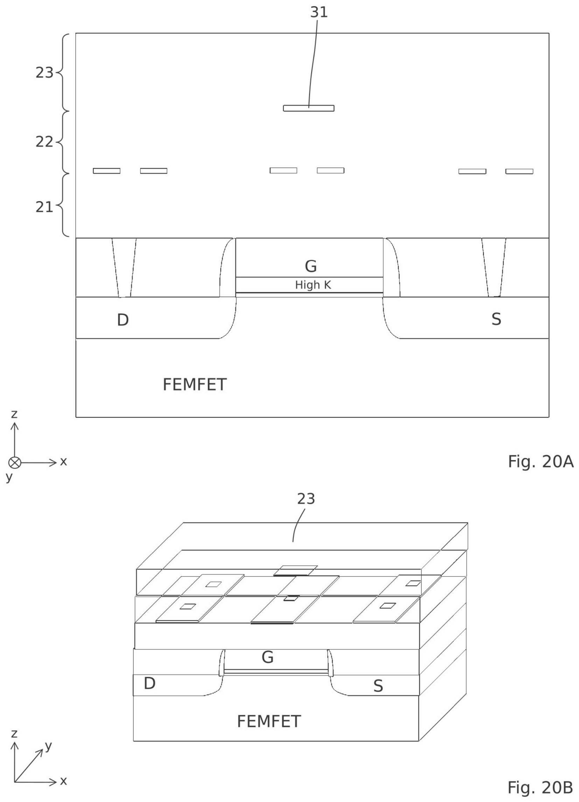

Comme illustré aux figures 20A, 20B, après structuration de la couche ferroélectrique 30a, une troisième couche métallique 23, typiquement à base d'un métal pris parmi TaN, TiN, AI, Ru, Mo, est ensuite formée sur la deuxième couche métallique 22, et sur le motif fermé 31. La troisième couche métallique 23 correspond typiquement à un troisième niveau de métal.

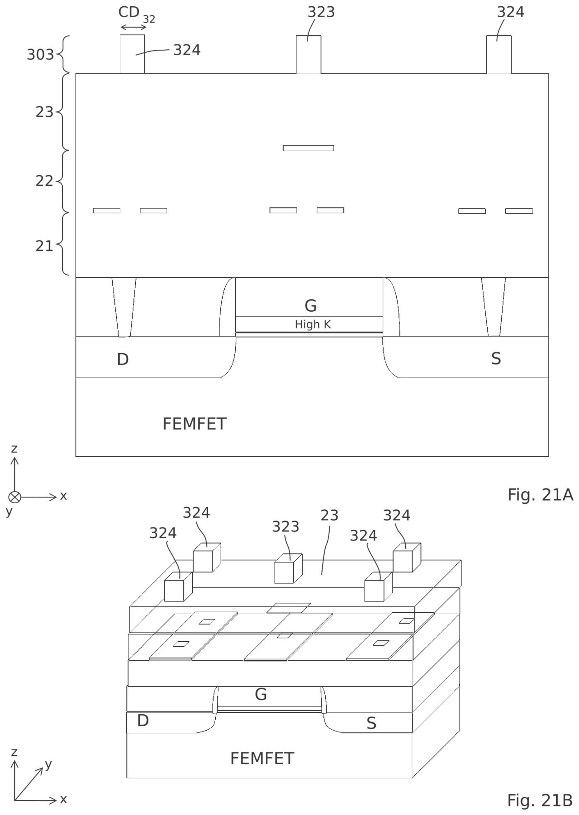

Comme illustré aux figures 21A, 21B, un troisième masque de gravure 303 comprenant des motifs de vias 323, 324 est formé sur la troisième couche métallique 23. Les motifs de vias 324 de ce troisième masque de gravure 303 sont alignés à l'aplomb des ouvertures de via 320 des motifs ouverts 32b. Le motif de via 323 de ce troisième masque de gravure 303 est aligné à l'aplomb du motif fermé 31. Les motifs de vias 324 présentent typiquement une dimension CD₃₂ selon x légèrement supérieure, par exemple 10% supérieure, à la dimension CDₒₚₑₙ selon x des ouvertures de via 320 des motifs ouverts 32b. Cela facilite l'alignement des motifs 324, 32a entre eux. La dimension CD₃₂ selon x des motifs de vias 324 est ici par exemple comprise entre 8 nm et 150 nm.

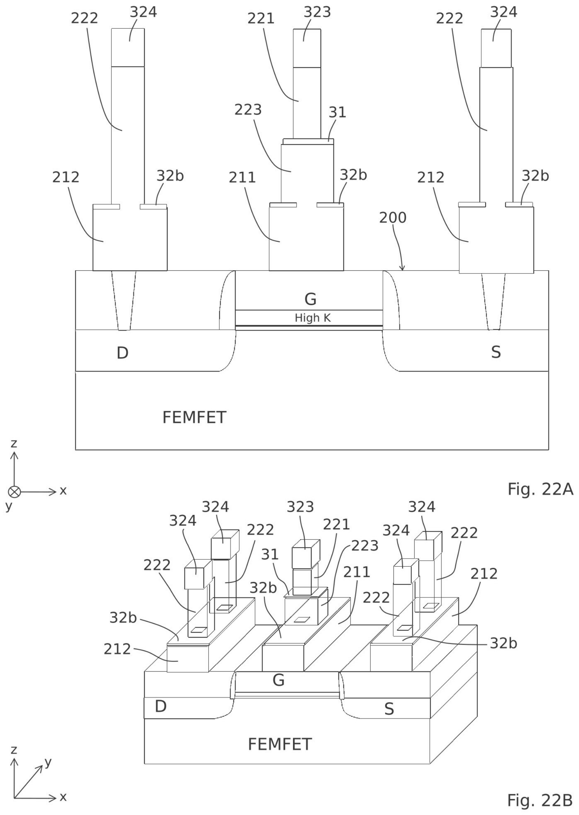

Comme illustré aux figures 22A, 22B, les première, deuxième et troisième couches métalliques 21, 22, 23 sont ensuite gravées sur toute leur épaisseur, selon z, de part et d'autre des motifs de vias 323, 324 et de part et d'autre des motifs ouverts 32b et du motif fermé 31. Les troisième et deuxième couches métalliques 23, 22 sont d'abord gravées pour former les vias 222, 221 et le plot 223, puis la première couche métallique 21 est gravée pour former les lignes 212, 211. Les gravures des première, deuxième et troisième couches métalliques 21, 22, 23 sont de préférence enchaînées. Selon une possibilité, notamment lorsque les première, deuxième et troisième couches métalliques 21, 22, 23 sont de nature identique, les gravures de ces couches métalliques 21, 22, 23 sont effectuées en une seule et même étape, avec la même chimie de gravure.

Les gravures sont ici choisies de façon à graver sélectivement les métaux des première, deuxième et troisième couches métalliques 21, 22, 23 vis-à-vis du matériau de la couche ferroélectrique (structurée sous forme du motif 31) et vis-à-vis du matériau de la couche d'arrêt de gravure (structurée sous forme des motifs 32b). La couche d'arrêt de gravure et la couche ferroélectrique sont utilisées comme couches d'arrêt de gravure. En particulier, la sélectivité de gravure S_{22:31}, c'est-à-dire le rapport entre la vitesse de gravure du métal de la deuxième couche métallique 22 sur la vitesse de gravure du matériau de la couche ferroélectrique, est supérieure ou égale à 5:1, de préférence supérieure ou égale à 10:1. La sélectivité de gravure S_{21:31}, c'est-à-dire le rapport entre la vitesse de gravure du métal de la première couche métallique 21 sur la vitesse de gravure du matériau de la couche ferroélectrique, est supérieure ou égale à 5:1, de préférence supérieure ou égale à 10:1. La sélectivité de gravure S_{21:30b}, c'est-à-dire le rapport entre la vitesse de gravure du métal de la première couche métallique 21 sur la vitesse de gravure du matériau de la couche d'arrêt de gravure 30b, est supérieure ou égale à 5:1, de préférence supérieure ou égale à 10:1. Les gravures peuvent être à base d'une chimie chlorée. Alternativement, la ou les gravures du ou des matériaux métalliques peuvent être effectuées en chimie fluorée ou fluoro-carbonée. Dans ce cas, il est préférable d'éviter SiN et SiO2 comme matériau diélectrique de la couche d'arrêt de gravure.

Un dispositif FeMFET comprenant des interconnexions I (212, 222) et un condensateur ferroélectrique F (211, 223, 31, 221) intégré dans les niveaux d'interconnexions est ainsi avantageusement obtenu. Le condensateur ferroélectrique F comprend ici une électrode inférieure formée par la ligne 211 et le plot 223, une électrode supérieure formée par le via 221, et une couche de séparation ferroélectrique 31 entre les électrodes inférieure et supérieure. Le condensateur ferroélectrique F est ici intégré entre les deuxième et troisième niveaux de métal.

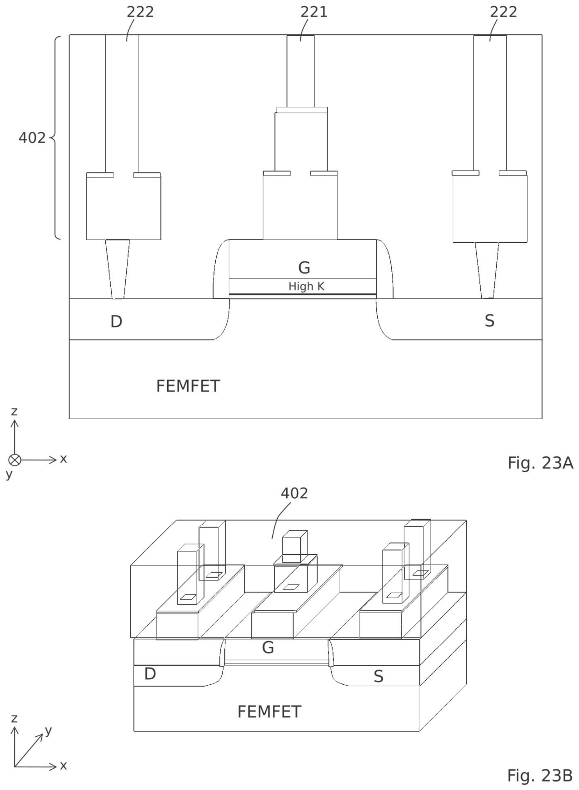

Comme illustré aux figures 23A, 23B, après retrait du masque 303, les interconnexions I et le condensateur ferroélectrique F sont ensuite classiquement intégrés dans une matrice diélectrique par dépôt et planarisation d'une couche diélectrique 402, typiquement à base de SiO₂.

Comme illustré aux figures 24A, 24B, une quatrième couche métallique 24 par exemple à base de TaN, TiN, AI, Ru, Mo, correspondant à un quatrième niveau de métal, peut ensuite être déposée sur la couche 402 et les vias 221, 222 affleurant. Comme précédemment, la quatrième couche métallique 24 peut être structurée sous forme de lignes 231 connectant les vias 221, 222.

L'invention n'est pas limitée aux modes de réalisations précédemment décrits. En particulier, il est envisageable de structurer la couche ferroélectrique et/ou la couche d'arrêt de gravure de façon indirecte, en formant des masques de gravure de polarité inverse puis en effectuant un dépôt localisé des matériaux de la couche ferroélectrique et/ou de la couche d'arrêt de gravure.

## Revendications

1. Dispositif FeMFET comprenant en empilement suivant une direction z :
- un transistor (1) comprenant une grille (10) surmontant un canal (11), une source (12) et un drain (13) de part et d'autre du canal (11),
- au moins une interconnexion (222, 212) connectant la source (12) ou le drain (13), comprenant :
∘ au moins une ligne métallique (212) à base d'un premier métal, et,
∘ au moins un via métallique (222) à base d'un deuxième métal, connecté à ladite au moins une ligne métallique (212),
∘ une couche d'arrêt de gravure (32a, 32b) intercalée entre l'au moins un via (222) et l'au moins une ligne (212), ladite couche d'arrêt de gravure (32a, 32b) comprenant au moins une ouverture de via (320) de sorte que l'au moins un via (222) et l'au moins une ligne (212) sont connectés au travers de ladite au moins une ouverture de via (320),
- un condensateur ferroélectrique connectant la grille (10), comprenant :
∘ au moins une ligne métallique (211) à base du premier métal, et,
∘ au moins un via métallique (221) à base du deuxième métal,
une première partie (31) d'une couche ferroélectrique (30a) intercalée entre l'au moins un via (221) et l'au moins une ligne (211), ladite couche ferroélectrique (31, 30a) séparant l'au moins un via (221) et l'au moins une ligne (211).

2. Dispositif selon la revendication précédente, dans lequel la couche d'arrêt de gravure (32a, 32b) intercalée entre l'au moins un via (222) et l'au moins une ligne (212) de l'au moins une interconnexion (222, 212) est ferroélectrique (30a).

3. Dispositif selon l'une quelconque des revendications précédentes, dans lequel l'au moins une interconnexion (222, 212) comprend une première interconnexion connectant la source (12) et une deuxième interconnexion connectant le drain (13), et dans lequel chacune des première et deuxième interconnexions comprend une couche d'arrêt de gravure (32a, 32b) intercalée entre l'au moins un via (222) et l'au moins une ligne (212) de ladite interconnexion (222, 212).

4. Dispositif selon l'une quelconque des revendications précédentes, dans lequel l'au moins un via métallique (222) de l'au moins une interconnexion (222, 212) connectant la source (12) ou le drain (13) présente une dimension critique CDᵥᵢₐ₂₂₂, prise selon un axe x, supérieure ou égale à une dimension CDₒₚₑₙ de l'au moins une ouverture de via (320) prise selon l'axe x.

5. Dispositif selon l'une quelconque des revendications précédentes, dans lequel l'au moins un via métallique (221) du condensateur ferroélectrique présente une dimension critique CDᵥᵢₐ₂₂₁, prise selon un axe x, strictement inférieure à une dimension CD₃₁, prise selon l'axe x, de la couche ferroélectrique (31) séparant l'au moins un via (221) et l'au moins une ligne (211) du condensateur ferroélectrique.

6. Dispositif selon l'une quelconque des revendications précédentes, dans lequel les premier et deuxième métaux sont à base du même métal pris parmi TaN, TiN, AI, Ru, Mo.

7. Procédé de fabrication d'un dispositif FeMFET selon l'une quelconque des revendications précédentes comprenant :
- une fourniture d'un transistor (1) comprenant une grille (10) surmontant un canal (11), une source (12) et un drain (13) de part et d'autre du canal (11), et des vias (14, 15) connectant la source (12) et le drain (13), lesdits vias (14, 15) et ladite grille (10) présentant chacun une face (140, 150, 100) exposée au niveau d'une surface supérieure (200),
- une formation d'une première couche métallique (21) sur les faces (140, 150, 100) exposées de la surface supérieure (200),
- une formation, sur la première couche métallique (21), d'une couche ferroélectrique (30a) à base d'un matériau ferroélectrique présentant, vis-à-vis de la première couche métallique (21), une sélectivité S_{21:30a} à la gravure supérieure ou égale à 5:1,
- une structuration de la couche ferroélectrique (30a), par l'intermédiaire d'au moins un premier masque (301), de façon à exposer des parties de la première couche métallique (21) et à conserver des parties de la couche ferroélectrique (30a) sous forme d'au moins un motif fermé (31) surmontant la grille (10) du transistor (1) et au moins un motif ouvert (32a) surmontant au moins un des vias (14, 15) connectant la source (12) ou le drain (13), ledit au moins un motif ouvert (32a) comprenant au moins une ouverture de via (320) débouchant sur la première couche métallique (21) sous-jacente,
- une formation d'une deuxième couche métallique (22) sur les parties exposées de la première couche métallique (21) et sur l'au moins un motif fermé (31) et l'au moins un motif ouvert (32a),
- une formation, sur la deuxième couche métallique (22), d'un deuxième masque (302) définissant au moins un deuxième niveau de vias à l'aplomb de l'au moins un motif fermé (31) et à l'aplomb de l'au moins une ouverture de via (320) de l'au moins un motif ouvert (32a),
- une gravure de la deuxième couche métallique (22), ladite gravure étant configurée pour former les vias (221, 222) du deuxième niveau en s'arrêtant sur la couche ferroélectrique (30a) et,
- une gravure de la première couche métallique (21) de part et d'autre de l'au moins un motif fermé (31) et de l'au moins un motif ouvert (32a), ladite gravure étant configurée pour former des lignes (211, 212) de premier niveau en s'arrêtant sur la surface supérieure (200).

8. Procédé de fabrication d'un dispositif FeMFET selon l'une quelconque des revendications 1 à 6 comprenant :
- une fourniture d'un transistor comprenant une grille surmontant un canal, une source et un drain de part et d'autre du canal, et des vias connectant la source et le drain, lesdits vias et ladite grille présentant chacun une face exposée au niveau d'une surface supérieure,
- une formation d'une première couche métallique sur les faces exposées de la surface supérieure,
- une formation, sur la première couche métallique, d'une couche d'arrêt de gravure (30b),
- une structuration de la couche d'arrêt de gravure (30b), par l'intermédiaire d'au moins un premier masque, de façon à exposer des parties de la première couche métallique et à conserver des parties de la couche d'arrêt de gravure (30b) sous forme d'au moins un motif ouvert (32b) surmontant la grille et au moins un via connectant la source ou le drain, ledit au moins un motif ouvert (32b) comprenant au moins une ouverture de via débouchant sur la première couche métallique sous-jacente,
- une formation d'une deuxième couche métallique sur les parties exposées de la première couche métallique et sur l'au moins un motif ouvert,
- une formation, sur la deuxième couche métallique, d'une couche ferroélectrique (30a) à base d'un matériau ferroélectrique présentant, vis-à-vis de la deuxième couche métallique, une sélectivité S_{22:30a} à la gravure supérieure ou égale à 5:1,
- une structuration de la couche ferroélectrique (30a), par l'intermédiaire d'au moins un deuxième masque, de façon à exposer des parties de la deuxième couche métallique et à conserver des parties de la couche ferroélectrique sous forme d'au moins un motif fermé (31) surmontant la grille du transistor,
- une formation d'une troisième couche métallique sur les parties exposées de la deuxième couche métallique et sur l'au moins un motif fermé,
- une formation, sur la troisième couche métallique, d'un troisième masque définissant des vias à l'aplomb de l'au moins un motif fermé (31) et à l'aplomb de l'au moins une ouverture de via de l'au moins un motif ouvert (32b),
- au moins une gravure des troisième, deuxième et première couches métalliques, ladite au moins une gravure étant configurée pour former les vias en s'arrêtant sur la couche ferroélectrique et sur la couche d'arrêt de gravure, et pour former des lignes en s'arrêtant sur la surface supérieure.

9. Procédé selon l'une quelconque des revendications 7 à8, dans lequel la couche ferroélectrique (30a) est à base d'un matériau pris parmi : HfₓZr₁₋ₓO₂, HfO₂.

10. Procédé selon l'une quelconque des revendications 7 à 9, dans lequel la couche ferroélectrique (30a) présente une épaisseur e₃₀ₐ comprise entre 2 nm et 15 nm, de préférence entre 7nm et 10nm.

11. Procédé selon l'une quelconque des revendications 7 à 10, dans lequel le ou les vias (221) du deuxième niveau surmontant l'au moins un motif fermé (31) présentent une dimension critique CDᵥᵢₐ₂₂₁, prise selon un axe x, inférieure à une dimension CD₁, prise selon l'axe x, de l'au moins un motif fermé (31).

12. Procédé selon l'une quelconque des revendications 7 à 11, dans lequel le ou les vias (222) du deuxième niveau surmontant l'au moins un motif ouvert (32a) présentent une dimension critique CDᵥᵢₐ₂₂₂, prise selon un axe x, supérieure ou égale à une dimension CDₒₚₑₙ de l'au moins une ouverture de via (320) prise selon l'axe x.

13. Procédé selon l'une quelconque des revendications 7 à 12, dans lequel les première et deuxième couches métalliques (21, 22) sont à base d'un même matériau métallique, par exemple TaN, TiN, AI, Ru, Mo.

14. Procédé selon l'une quelconque des revendications 7 à 13, dans lequel la gravure de la deuxième couche métallique (22) et la gravure de la première couche métallique (21) sont réalisées par une seule et même gravure, lors d'une seule et même étape.
